# EUROPEAN PATENT SPECIFICATION

(11) **EP 1 650 814 B1**
(45) Date of publication and mention of the grant of the patent: **22.12.2010**
(21) Application number: 05109760.8
(22) Date of filing: 19.10.2005
(51) Int. Cl.: H01L 31/075

(54) **Tandem thin film solar cell**
Tandem Dünnschicht-Solarzelle
Cellule solaire tandem en couches minces

(30) Priority: 20.10.2004 JP 2004305144
(43) Date of publication of application: 26.04.2006
(73) Proprietor: MITSUBISHI HEAVY INDUSTRIES, LTD., Tokyo 108-8215 (JP)
(72) Inventor: Nakano, Youji c/o MITSUBISHI HEAVY INDUSTRIES,LTD., Kanazawa-ku,Yokohama Kanagawa (JP); Yamashita, Nobuki c/o MITSUBISHI HEAVY iNDUSTRIES,LTD., Kanazawa-ku, Yokohama Kanagawa (JP)
(74) Representative: Bongiovanni, Simone

(56) References cited:
- EP-A- 0 554 877
- EP-A- 1 478 030
- JP-A- 10 117 006
- US-A- 5 456 762
- US-A1- 2003 213 515

## Description

### Background of the Invention

### 1. Field of the Invention

The present invention relates to tandem thin film solar cells.

### 2. Description of the Related Art

The development of solar cells is often directed to the following techniques as follows:
(1) A technique for improving efficiency of introduction of sunlight into the energy conversion region, typically including a pin junction formed of semiconductor material.
(2) A technique for improving efficiency of conversion of the solar energy into electrical energy in the energy conversion region.
Improving these efficiencies effectively achieves total power efficiency of solar cells.

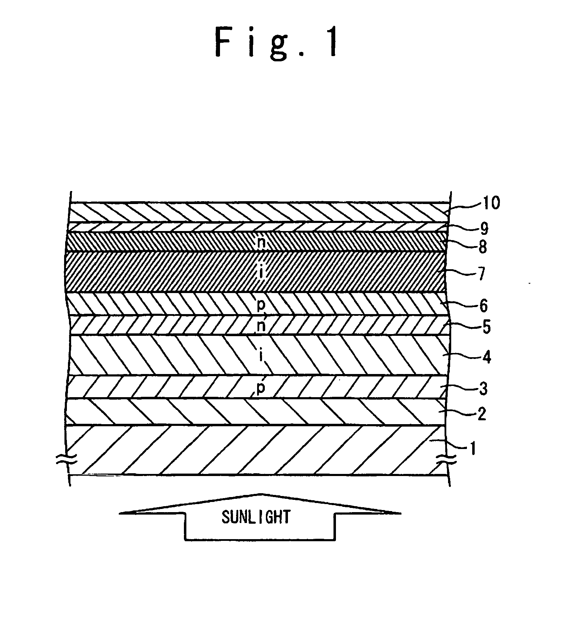

Fig. 1 is a schematic section view illustrating a structure of a conventional thin film stacked solar cell adopting a tandem structure. The conventional solar cell is composed of a stack formed of a transparent insulative substrate 1, a first transparent electrode 2, a P-type amorphous silicon layer 3, an I-type amorphous silicon layer 4, an N-type amorphous silicon layer 5, a P-type polycrystalline silicon layer 6, an I-type polycrystalline silicon layer 7, an N-type polycrystalline silicon layer 8, and a second transparent electrode 9, and a rear electrode 10.

The P-type amorphous silicon layer 3, the I-type amorphous silicon layer 4, and the N-type amorphous silicon layer 5 function as an amorphous silicon solar cell. These amorphous silicon layers may be formed of silicon based semiconductor material mainly containing silicon, such as silicon carbide including carbon less than 50 atomic %, and silicon germanium including germanium less than 20 atomic %. The amorphous silicon layers may be doped with other minor elements less than several %. The crystallinities of the P-type amorphous silicon layer 3 and the N-type amorphous silicon layer 5 are not so important; the amorphous silicon solar cell requires that only the major portion of the I-type amorphous silicon layer 4 is amorphous, which mainly provides photoelectric conversion.

On the other hand, the P-type polycrystalline silicon layer 6, the I-type polycrystalline silicon layer 7, and the N-type polycrystalline silicon layer 8 function as a polycrystalline silicon solar sell. These polycrystalline silicon layers may be formed of silicon based semiconductor material mainly containing silicon, such as silicon carbide including carbon less than 50 atomic %, and silicon germanium including germanium less than 20 atomic %. The polycrystalline silicon layers may be doped with other minor elements less than several %. The crystallinities of the P-type polycrystalline silicon layer 6 and the N-type amorphous silicon layer 8 are not so important; the polycrystalline silicon solar cell requires that only the major portion of the I-type amorphous silicon layer 4 is polycrystalline, which mainly provides photoelectric conversion.

The solar light entering through the transparent substrate 1 is firstly converted into electrical energy within the amorphous silicon solar cell. The remaining solar light, which is not absorbed in the amorphous silicon solar cell, then enters the polycrystalline silicon solar cell, and is additionally converted into electrical energy.

In the solar cell shown in Fig. 1, the thickness of the first transparent electrode 2 is adjusted so that the solar light is introduced thereinto as much as possible. Additionally, the film qualities of amorphous silicon layers are improved with defects of the layers reduced for reduction of light-induced degradation (that is, improvement of stabilized conversion efficiency); the light-induced degradation is knows an a phenomenon that an amorphous solar cell suffers from reduction in production of electric power after exposure of light.

There are a lot of remaining issues on solar cell technologies, such as optimization of stacked structure of solar cells, and thicknesses of layers within the solar cells. Especially, the thicknesses of amorphous layers within the amorphous silicon solar cell are desired to be thin to reduce the light-induced degradation and to thereby improve the stabilization efficiency. Additionally, the thicknesses of polycrystalline layers within the polycrystalline silicon solar cell are desired to be thin for improving the power generation efficiency and productivity. Furthermore, a power current of a tandem type solar cell mainly depends on less one of the power currents of the amorphous silicon solar cell and the polycrystalline silicon solar cell, because the amorphous and polycrystalline solar cells are serially connected within the tandem type solar cell. Therefore, the balance of the power currents of the amorphous silicon solar cell and the polycrystalline silicon solar cell is important. The optimization of the thicknesses of layers within the solar cell on the basis of these situations becomes increasingly important.

Various approaches for dealing such situations have been proposed.

Japanese Laid Open Patent Application No. H10-117006 discloses a thin film photoelectric converter apparatus composed of a substantially polycrystalline photoelectric conversion layer having first and second main surfaces, and a metal thin film covering the second main surface. The polycrystalline photoelectric conversion layer, which is substantially composed of polycrystalline silicon thin films, has an average thickness of 0.5 to 20 µm. The first main surface has a textured structure. The textured structure is provided with tiny bumps of heights less than the half of the average thickness, the heights substantially ranging between 0.05 to 3 µm.

Japanese Laid Open Patent Application No. 2001-177134 discloses an integrated hybrid thin film photoelectric converter apparatus composed of a transparent electrode layer, an amorphous semiconductor photoelectric conversion unit layer, a polycrystalline semiconductor photoelectric conversion unit layer, and a rear electrode, which are sequentially laminated to cover a transparent insulative substrate. The stack of the transparent electrode layer, the amorphous semiconductor photoelectric conversion unit layer, the polycrystalline semiconductor photoelectric conversion unit layer, and the rear electrode is divided by separating grooves formed in parallel through laser scribing to thereby form a set of hybrid photoelectric converter cells. The hybrid photoelectric converter cells are electrically connected in series by connecting grooves formed in parallel with the separating grooves. This publication discloses that the thickness of an amorphous photoelectric conversion layer within the amorphous photoelectric conversion unit layer is 250 nm or more, while the thickness of an polycrystalline photoelectric conversion layer within the polycrystalline photoelectric conversion unit layer is 3 µm or less, the thickness of the polycrystalline photoelectric conversion layer being in a range of four to eight times of the amorphous photoelectric conversion layer.

Japanese Laid Open Patent Application No. 2002-118273 discloses an integrated hybrid thin film photoelectric converter apparatus composed of a transparent electrode layer, an amorphous semiconductor photoelectric conversion unit layer, a conductive optical intermediate layer partially reflecting and transmitting light, a polycrystalline semiconductor photoelectric conversion unit layer, and a rear electrode, which are sequentially laminated to cover a transparent insulative substrate. The stack of the transparent electrode layer, the amorphous semiconductor photoelectric conversion unit layer, the polycrystalline semiconductor photoelectric conversion unit layer, and the rear electrode is divided by separating grooves formed in parallel through laser scribing to thereby form a set of hybrid photoelectric converter cells. The hybrid photoelectric converter cells are electrically connected in series by connecting grooves formed in parallel with the separating grooves. This publication discloses that the thickness of the amorphous photoelectric conversion unit layer is in a range of 0.01 to 0.5 µm, and the thickness of the polycrystalline photoelectric conversion unit layer is in a range of 0.1 to 10 µm, wherein the optical intermediate layer has a thickness of 10 to 100 nm and a resistively of 1 x 10⁻³ to 1 x 10⁻¹ Ω·cm.

EP-A-1 478 030, comprised in the stare of the art under art. 54(3) EPC, discloses a tandem thin film solar cell having the features of the preamble of claim 1, wherein the first conductive layer has a surface irregularity with a pitch in the range of 0.2 to 0.9 µm.

However, this document does not provide any information concerning the amplitude of the surface irregularity or the ratio of the amplitude to the pitch.

Document US-B-6,388,301 describes a tandem solar cell with irregular surfaces.

### Summary of the Invention

Therefore, the present invention addresses providing a tandem thin film solar cell superior in conversion efficiency and productivity.

In an aspect of the present invention, a tandem thin film solar cell is composed of a first conductive layer formed on a transparent substrate through which the sunlight enters the tandem thin film solar cell; a first solar cell layer formed on the first conductive layer; and a second solar cell layer covering the first solar cell layer. The first conductive layer has surface irregularity, a pitch of the surface irregularity being in a range of 0.2 to 2.5 µm, and an amplitude of the surface irregularity being in a range of one-third to half of the pitch of the surface irregularity.

In one embodiment, the first solar cell layer is an amorphous silicon solar cell mainly formed of amorphous silicon, the amorphous silicon solar cell including: a first silicon layer of first conductivity type selected out of P-type and N-type; an I-type amorphous silicon layer; and a second silicon layer of second conductivity type different from the first conductivity type, while the second solar cell layer is a polycrystalline silicon solar cell mainly formed of polycrystalline silicon, the polycrystalline silicon solar cell including: a third silicon layer of third conductivity type selected out of P-type and N-type; an I-type amorphous silicon layer; and a fourth silicon layer of fourth conductivity type different from the third conductivity type.

It is preferable that a thickness of the first solar cell layer is in a range of 200 to 400 nm, and a thickness of the second solar cell layer is in a range of 1.5 to 3.0 µm.

Preferably, the tandem thin film solar cell may further include an intermediate conductive layer formed between the first solar cell layer and the second solar cell layer.

In this case, it is preferable that a thickness of the first solar cell layer is in a range of 100 to 400 nm, and a thickness of the second solar cell layer is in a range of 1.0 to 3.0 µm.

In a preferred embodiment, the intermediate conductive layer is mainly formed of material selected out of ZnO, SnO₂, and indium tin oxide, and the intermediate conductive layer has a light absorption rate less than 1 % at wavelengths of 600 to 1200 nm.

The tandem thin film solar cell is preferably comprised of a second conductive layer covering the second solar cell layer, the second conductive layer being formed of silver.

In this case, the tandem thin film solar cell is preferably comprised of a third conductive layer formed between the second solar cell layer and the second conductive layer. The third conductive layer is preferably mainly formed of ZnO, having a thickness of 20 to 100 nm.

### Brief Description of the Drawings

The above and other advantages and features of the present invention will be more apparent from the following description taken in conjunction with the accompanied drawings, in which:
Fig. 1 is a section view schematically illustrating an exemplary structure of a conventional tandem thin film solar cell;
Fig. 2 is a section view schematically illustrating an exemplary structure of a tandem thin film solar cell in a first embodiment of the present invention;
Fig. 3 is a graph illustrating the association of the thicknesses of an amorphous silicon solar cell and a polycrystalline silicon solar cell within a tandem thin film solar cell with the stabilized conversion efficiency thereof in a second embodiment;
Fig. 4 is a section view schematically illustrating an exemplary structure of a tandem thin film solar cell in a third embodiment of the present invention;
Fig. 5 is a table illustrating an association of the thickness of a transparent intermediate layer within a tandem thin film solar cell with the quantum efficiency of a polycrystalline silicon solar cell at a wavelength of 800 nm.
Fig. 6 is a graph illustrating the association of the thicknesses of an amorphous silicon solar cell and a polycrystalline silicon solar cell within a tandem thin film solar cell with the stabilized conversion efficiency thereof in a fifth embodiment; and
Fig. 7 is a table illustrating an association of the thickness of a second transparent electrode within a tandem thin film solar cell with the stabilized conversion efficiency thereof.

### Description of the Preferred Embodiments

The invention will be now described herein with reference to the attached drawings..

The present invention is directed to improve conversion efficiency and productivity of a solar cell. In order to achieve this, surface morphology of a first transparent electrode to which the sunlight is incident is optimized, including pitch and amplitude of surface irregularity. This effectively improves the stabilized conversion efficiency of the solar cell through increasing the travel distance in the solar cell. Additionally, a tandem solar cell is presented in which thicknesses of an amorphous silicon solar cell and a polycrystalline silicon solar cell are optimized.

It should be noted that the thickness of the amorphous silicon solar cell is desirably thin to improve the stabilized conversion efficiency. Additionally, the thickness of the polycrystalline silicon solar cell is desirably thin to improve both of the stabilized conversion efficiency and productivity.

Embodiments described in the following provide solar cells with improved stabilized conversion efficiency and productivity through appropriately balancing the thicknesses of layers within the solar cell.

### First Embodiment

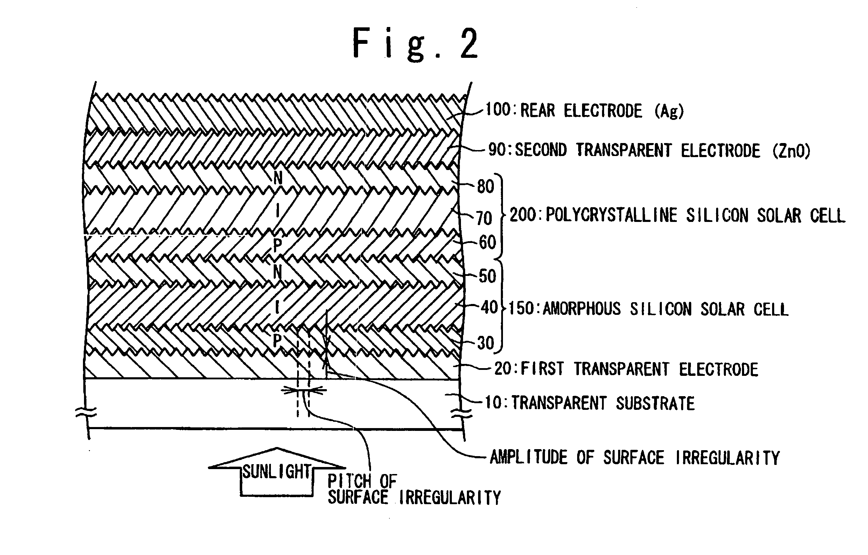

Fig. 2 is a section view illustrating an exemplary section structure of a tandem thin film solar cell in a first embodiment of the present invention.

The tandem thin film solar cell in this embodiment is composed of a transparent insulative substrate 10, a first transparent electrode 20, an amorphous silicon solar cell 150, a polycrystalline silicon solar cell 200, a second transparent electrode 90, and a rear electrode 100. The first transparent electrode 20 is formed of ITO (indium tin oxide), and the second transparent electrode 90 is formed of ZnO. The rear electrode 100 is formed of metal, such as silver (Ag).

The amorphous silicon solar cell 150 is composed of a P-type amorphous silicon layer 30, an I-type amorphous silicon layer 40 and an N-type amorphous silicon layer 50. It should be noted that the order of the layers within the amorphous silicon solar cell 150 may be reversed; the amorphous silicon solar cell 150 may adopt a PIN structure or an NIP structure. Correspondingly, the polycrystalline silicon solar cell 200 is composed of a P-type polycrystalline silicon layer 60, an I-type polycrystalline silicon layer 70, and an N-type polycrystalline silicon layer 80. It should be also noted that the order of the layers within the polycrystalline silicon solar cell 200 may be reversed; the polycrystalline silicon solar cell 200 may adopt a PIN structure or an NIP structure.

The main surface of the first transparent electrode 20, on which the amorphous silicon solar cell 150 is formed, is textured, exhibiting surface irregularity. The pitch of the surface irregularity is selected in a range of 0.2 to 2.5 µm, and the amplitude of the surface irregularity is selected in a range of one-fourth to half of the pitch of the surface irregularity. In this embodiment, as shown in Fig. 2, the pitch of the surface irregularity is defined as being the intervals of the roots on the main surface of the first transparent electrode 20, while the amplitude of the surface irregularity is defined as being the heights of the crests of the first transparent electrode 20 from the roots thereof.

In this embodiment, the pitch of the surface irregularity of the first transparent electrode 20 is 0.6 µm, while the amplitude thereof is 0.2 µm. The morphologies of the layers covering the first transparent electrode 20 depend on the surface irregularity of the first transparent electrode 20.

The surface irregularity of the first transparent electrode 20 effectively increases the optical travel distance within the amorphous silicon solar cell 150 and the polycrystalline silicon solar cell 200 by scattering the incident sunlight. It is preferable for maximizing the scattering coefficient of the first transparent electrode 20 that the pitch of the surface irregularity is approximately equal to the wavelengths of the light to be scattered (that is, the sunlight), and that the amplitude of the surface irregularity is approximately equal to the one-third of the pitch of the surface irregularity; this resulting from the fact that silicon has a relative refractive index of approximately 3.

Experimental results are given in the following. For the case that the amorphous silicon solar cell 150 has a thickness of 300 nm, and the polycrystalline silicon solar cell 200 has a thickness of 2 µm, the stabilized conversion efficiency of the tandem solar cell in this embodiment is 11.5 % with the sunlight of AM (air mass) 1.5; the stabilized conversion efficiency is defined as being the conversion efficiency after causing light-induced degradation by irradiating light under conditions of 1 SUN (that is, 100 mW/cm²) at 50 °C for 1000 hours, or under accelerating conditions equivalent thereto.

Stabilized efficiencies of comparative samples (a) to (c) are tested under the same conditions. The comparative sample (a) is provided with a first transparent electrode having a surface irregularity of 0.2 µm in pitch and 0.1 µm in amplitude. The comparative sample (b) is provided with a first transparent electrode having a surface irregularity of 0.5 µm in pitch and 0.8 µm in amplitude. Finally, the comparative sample (c) is provided with a first transparent electrode having a surface irregularity of 4.0 µm in pitch and 1.0 µm in amplitude. The thicknesses of the amorphous silicon solar cells within the comparative samples (a) to (c) are 300 nm, and the thicknesses of the polycrystalline silicon solar cells within the comparative samples (a) to (c) are 2.0 µm. The stabilized conversion efficiencies of the comparative samples (a) to (c) are 10.7%, 10.7%, and 10.2%, respectively. This result confirms that the tandem solar cell in this embodiment achieves superior stabilized conversion efficiency superior compared to the comparative samples.

The high stabilized conversion efficiency of the tandem solar cell in this embodiment results from the fact that the component of wavelengths of 700-900 nm of the sunlight, which contributes the power current within the polycrystalline silicon solar cell 200, is effectively scattered, and the conversion efficiency of the polycrystalline silicon solar cell 200 is thereby effectively improved.

In summary, the tandem thin film solar cell in this embodiment achieves a stabilized conversion efficiency equal to or more than 10.5% through providing a surface irregularity on the first transparent electrode 20, the pitch of the surface irregularity being 0.2 to 2.5 µm, and the amplitude thereof being one-fourth to half of the pitch. This provides the tandem thin film solar cell in this embodiment with a stabilized conversion efficiency increased up to 11.5%.

### Second Embodiment

The section structure of a tandem thin film solar cell in a second embodiment is almost identical to that in the first embodiment. The difference is that the thicknesses of the amorphous silicon solar cell 150 and the polycrystalline silicon solar cell 200 are additionally optimized in the second embodiment.

The power current of the tandem solar cell in this embodiment depends on less one of the power currents of the amorphous silicon solar cell 150, which functions as a top cell, and the polycrystalline silicon solar cell 200, which functions as a bottom cell. The power current of the amorphous silicon solar cell 150 increases as the thickness thereof increases. On the other hand, the power current of the polycrystalline silicon solar cell 200 depends on the light intensity of the sunlight that is not absorbed in the top cell; the intensity of the sunlight that reaches the polycrystalline silicon solar cell 200 increases as the thickness of the amorphous silicon solar cell 150 decreases. For the same intensity of the sunlight that reaches the polycrystalline silicon solar cell 200, the power current of the polycrystalline silicon solar cell 200 increases as the thickness thereof increases. Therefore, a balanced point exists in the relation between the thicknesses of the amorphous silicon solar cell 150 and the polycrystalline silicon solar cell 200.

Increasing the thickness of the amorphous silicon solar cell 150, on the other hand, undesirably causes inferior productivity. The increase in the thickness of the amorphous silicon solar cell 150 additionally causes severe light-induced degradation. Therefore, there should be a proper value of the thickness of the amorphous silicon solar cell 150.

Furthermore, increasing the thickness of the polycrystalline silicon solar cell 200 undesirably causes reduction in the power voltage due to the increase in the defects and the reduction in the potential gradient across the layers of the polycrystalline silicon solar cell 200. Therefore, there should be a proper value of the thickness of the polycrystalline silicon solar cell 200.

In this embodiment, the thickness of the amorphous silicon solar cell 150 is selected in a range of 200 to 400 nm, and the thickness of the polycrystalline silicon solar cell 200 is selected in a range of 1.5 to 3.0 µm. This effectively achieves superior stabilized conversion efficiency and productivity as described in the following.

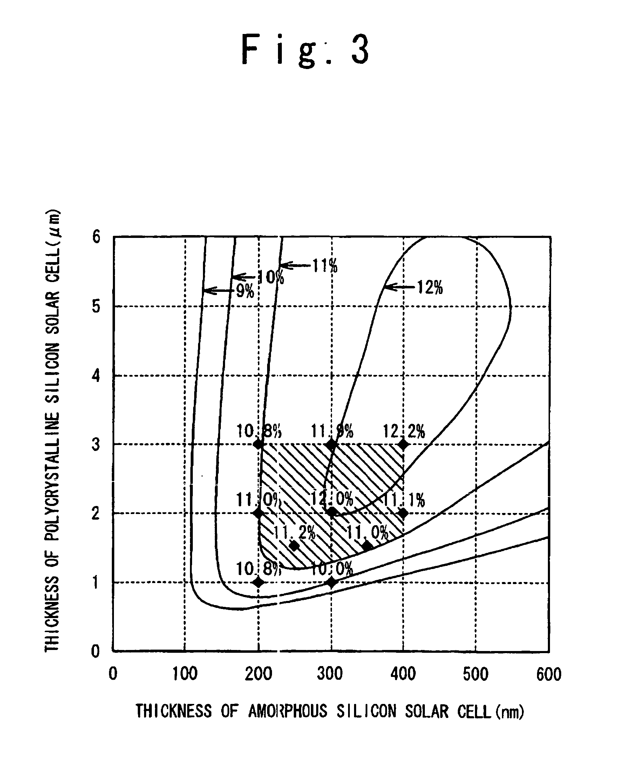

Fig. 3 is a graph illustrating the association of the thicknesses of the amorphous silicon solar cell 150 and the polycrystalline silicon solar cell 200 with the stabilized conversion efficiency of the tandem thin film solar cell in this embodiment. The symbols "◆" in Fig. 3 indicate measured values of stabilized conversion efficiencies, and the lines indicate the simulation results. The tests are implemented under the conditions of AM 1.5, which is in accordance with the JIS (Japanese Industry Standard) C8934. As known in the art, amorphous silicon solar cell suffers from light-induced degradation in practical use. As is the case of the first embodiment, stabilized conversion efficiencies are defined as conversion efficiencies after the light-induced degradation under conditions of 1 SUN (that is, 100 mW/cm²) at 50 °C for 1000 hours, or under accelerating conditions equivalent thereto.

In order to achieve both a superior stabilized conversion efficiency of 11% and superior productivity, as shown in Fig. 3, it is advantageous that the amorphous silicon solar cell 150 has a thickness of 200 to 400 nm, and the polycrystalline silicon solar cell 200 has a thickness of 1.5 to 3.0 µm; the advantageous thickness range is indicated as the hatched area in Fig. 3. It should be noted that the amorphous silicon solar cell 150 are required to be reduced in thickness down to 400 nm or less and the polycrystalline silicon solar cell 200 are required to be reduced in thickness down to 3.0 µm or less, for achieving superior productivity. The advantageous thickness range shown in Fig. 3 effectively achieves stabilized conversion efficiency up to about 12%.

As thus described, the thicknesses of the amorphous silicon solar cell 150 and the polycrystalline silicon solar cell 200 are additionally optimized to increases the stabilized conversion efficiency in the second embodiment. This provides a tandem thin film solar cell superior in the efficiency and productivity compared to that presented in the first embodiment.

### Third Embodiment

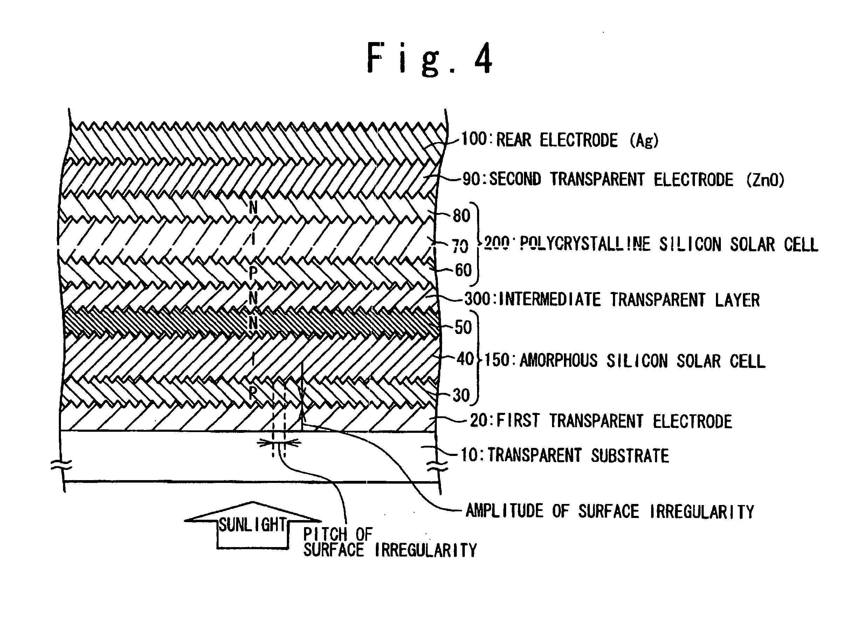

Fig. 4 is a section view illustrating an exemplary section structure of a tandem thin film solar cell in a third embodiment of the present invention. The section structure of a tandem thin film solar cell in a third embodiment is almost identical to that in the first embodiment. The difference is that a transparent intermediate layer 300 is disposed between an amorphous silicon solar cell 150 and a polycrystalline silicon solar cell 200 in this embodiment.

Specifically, the tandem thin film solar cell in this embodiment is composed of a transparent insulative substrate 10, a first transparent electrode 20, a second transparent electrode 90, and a rear electrode 100. The amorphous silicon solar cell 150 and the polycrystalline silicon solar cell 200 are disposed between the first and second transparent electrodes 20 and 90. The transparent intermediate layer 300 is disposed between the amorphous silicon solar cell 150 and a polycrystalline silicon solar cell 200. The amorphous silicon solar cell 150 is composed of a P-type amorphous silicon layer 30, an I-type amorphous silicon layer 40 and an N-type amorphous silicon layer 50. It should be noted that the order of the layers within the amorphous silicon solar cell 150 may be reversed; the amorphous silicon solar cell 150 may adopt a PIN structure or an NIP structure. Correspondingly, the polycrystalline silicon solar cell 200 is composed of a P-type polycrystalline silicon layer 60, an I-type polycrystalline silicon layer 70, and an N-type polycrystalline silicon layer 80. It should be also noted that the order of the layers within the polycrystalline silicon solar cell 200 may be reversed; the polycrystalline silicon solar cell 200 may adopt a PIN structure or an NIP structure.

The main surface of the first transparent electrode 20, on which the amorphous silicon solar cell 150 is formed, is textured, exhibiting surface irregularity. The pitch of the surface irregularity is in a range of 0.2 to 2.5 µm, and the amplitude of the surface irregularity is in the range of one-fourth to half of the pitch of the surface irregularity. In this embodiment, the pitch of the surface irregularity of the first transparent electrode 20 is 0.6 µm, while the amplitude thereof is 0.2 µm.

In this embodiment, the transparent intermediate layer 300 partially reflects the incident sunlight, and the reflected sunlight re-enters the amorphous silicon solar cell 150.

This effectively increases the power current of the top cell (that is, the amorphous silicon solar cell 150), and allows the reduction in the thickness of the top cell for achieving the same power current as the case without the transparent intermediate layer 300. The reduction in the thickness of the amorphous silicon solar cell 150 reduces the influence of light-induced degradation, and effectively improves the total stabilized conversion efficiency of the tandem thin film solar cell.

In a preferred embodiment, the amorphous silicon solar cell 150 has a thickness of 250 nm, and the polycrystalline silicon solar cell 200 has a thickness of 2.0 µm. Additionally, the transparent intermediate layer 300 has a thickness of 60 nm, and is formed of ZnO doped with germanium of 1.5 atomic %, deposited thorough sputtering in an oxygen-including atmosphere. This structure achieves a stabilized conversion efficiency of 12.4%. It should be noted that the transparent intermediate layer 300 may be mainly formed of ZnO, and may be doped with germanium or aluminum. The transparent intermediate layer 300 may be formed of undoped ZnO.

As thus described, the transparent intermediate layer 300 is disposed between the amorphous silicon solar cell 150, which functions as a top cell, and the polycrystalline silicon solar cell 200, which functions as a bottom cell. This effectively increases the power current of the amorphous silicon solar cell 150. This also allows reduction in the thickness of the amorphous silicon solar cell 150, and thereby improves the stabilized conversion efficiency of the tandem thin film solar cell, compared to those presented in the first and second embodiments.

### Fourth Embodiment

In a fourth embodiment, the thickness of the transparent intermediate layer 300 within the tandem thin film solar cell is optimized to improve the stabilized conversion efficiency.

Increasing the transparent intermediate layer 300 effectively increases the power current of the amorphous silicon solar cell 150, which functions as a top cell. It should be noted that this is accompanied by the reduction in the power current of the polycrystalline silicon solar cell 200, which functions as a bottom cell, at the wavelengths of the sunlight reflected by the transparent intermediate layer 300. Actually, the polycrystalline silicon solar cell 200 provides photoelectric conversion at the wavelength range longer than that at which the amorphous silicon solar cell 150.

Therefore, the optimization of the thickness of the transparent intermediate layer 300 is desired to reduce the absorption of the sunlight at the longer wavelength range at which the polycrystalline silicon solar cell 200, functioning as the top cell, is designed to absorb the sunlight.

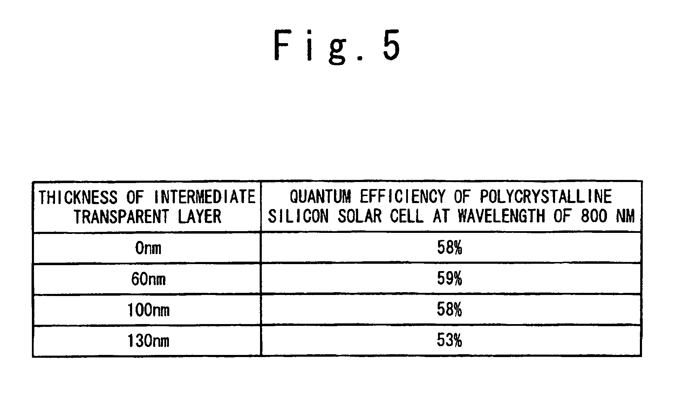

Fig. 5 is a table illustrating an association of the thickness of the transparent intermediate layer 300 with the quantum efficiency of the polycrystalline silicon solar cell 200 at the wavelength of 800 nm. It should be noted that the wavelength of 800 nm corresponds to the longer wavelength range of the sunlight, and the quantum efficiency is defined as the ratio of the number of charge carriers collected by the solar cell to the number of photons. The increase in the thickness of the transparent intermediate layer 300 results in the increase in the reflection coefficient of the transparent intermediate layer 300 in the longer wavelength range of the sunlight, and thereby reduces the intensity of the light that enters the polycrystalline silicon solar cell 200.

Additionally, the increase in the thickness of the transparent intermediate layer 300 enhances optical confinement effect between the transparent intermediate layer 300 and the rear electrode 100. As a result, the absorption efficiency of the sunlight entering the polycrystalline silicon solar cell 200 is increased. As shown in Fig. 5, the optical confinement effect is effectively achieved (that is, the quantum efficiency is maintained at a substantially constant value) for the sunlight of the wavelength of 800 nm when the thickness of the transparent intermediate layer 300 is reduced down to 100 nm or less.

As thus described, this embodiment addresses the optimization of the thickness of the transparent intermediate layer 300, balancing the power currents of the amorphous silicon solar cell 150 and the polycrystalline solar cell 200. This effectively provides a tandem thin film solar cell with high stabilized conversion efficiency.

### Fifth Embodiment

The section structure of a tandem thin film solar cell in a fifth embodiment is almost identical to that in the third embodiment. The difference is that the thicknesses of the amorphous silicon solar cell 150 and the polycrystalline silicon solar cell 200 are additionally optimized in the fifth embodiment.

The power current of the tandem solar cell in this embodiment depends on less one of the power currents of the amorphous silicon solar cell 150, which functions as a top cell, and the polycrystalline silicon solar cell 200, which functions as a bottom cell for the same thickness of the transparent intermediate layer 300. The power current of the amorphous silicon solar cell 150 increases as the thickness thereof increases. On the other hand, the power current of the polycrystalline silicon solar cell 200 depends on the light intensity of the sunlight that is not absorbed in the top cell; the intensity of the sunlight that reaches the polycrystalline silicon solar cell 200 increases as the thickness of the amorphous silicon solar cell 150 decreases. For the same intensity of the sunlight that reaches the polycrystalline silicon solar cell 200, the power current of the polycrystalline silicon solar cell 200 increases as the thickness thereof increases. Therefore, a balanced point exists in the relation between the thicknesses of the amorphous silicon solar cell 150 and the polycrystalline silicon solar cell 200.

Increasing the thickness of the amorphous silicon solar cell 150, on the other hand, undesirably causes inferior productivity. The increase in the thickness of the amorphous silicon solar cell 150 additionally causes severe light-induced degradation. Therefore, there should be a proper value of the thickness of the amorphous silicon solar cell 150.

Furthermore, increasing the thickness of the polycrystalline silicon solar cell 200 undesirably causes reduction in the power voltage due to the increase in the defects and the reduction in the potential gradient across the layers of the polycrystalline silicon solar cell 200. Therefore, there should be a proper value of the thickness of the polycrystalline silicon solar cell 200.

In this embodiment, the thickness of the amorphous silicon solar cell 150 is selected in a range of 100 to 400 nm, and the thickness of the polycrystalline silicon solar cell 200 is selected in a range of 1.0 to 3.0 µm. This effectively achieves superior stabilized conversion efficiency and productivity as described in the following.

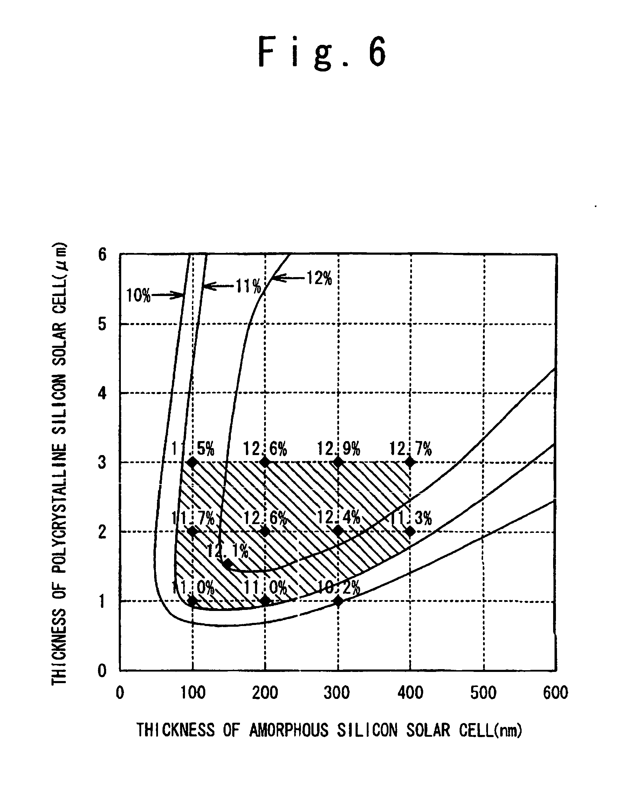

Fig. 6 is a graph illustrating the association of the thicknesses of the amorphous silicon solar cell 150 and the polycrystalline silicon solar cell 200 with the stabilized conversion efficiency of the tandem thin film solar cell in this embodiment. The symbols "◆" in Fig. 6 indicate measured values of stabilized conversion efficiencies, and the lines indicate the simulation results. The tests are implemented under the conditions of AM 1.5, which is in accordance with the JIS (Japanese Industry Standard) C8934. As known in the art, amorphous silicon solar cell suffers from light-induced degradation in practical use. As is the case of the first embodiment, stabilized conversion efficiencies are defined as conversion efficiencies after the light-induced degradation under conditions of 1 SUN (that is, 100 mW/cm²) at 50 °C for 1000 hours, or under accelerating conditions equivalent thereto.

In order to achieve both a superior stabilized conversion efficiency of 11% and superior productivity, as shown in Fig. 6, it is advantageous that the amorphous silicon solar cell 150 has a thickness of 100 to 400 nm, and the polycrystalline silicon solar cell 200 has a thickness of 1.0 to 3.0 µm; the advantageous thickness range is indicated as the hatched area in Fig. 6. It should be noted that the amorphous silicon solar cell 150 are required to be reduced in thickness down to 400 nm or less and the polycrystalline silicon solar cell 200 are required to be reduced in thickness down to 3.0 µm or less, for achieving superior productivity. The advantageous thickness range shown in Fig. 6 effectively achieves stabilized conversion efficiency up to about 13%.

In summary, this embodiment addresses optimization of the thicknesses of the amorphous silicon solar cell 150 and the polycrystalline silicon solar cell 200 within the tandem thin film silicon solar cell incorporating the transparent intermediate layer 300. This provides a tandem thin film solar cell with superior stabilized conversion efficiency and productivity compared to that presented in the third embodiment, that is, achieves high stabilized conversion efficiency with reduced thicknesses of the amorphous silicon solar cell 150 and the polycrystalline silicon solar cell 200.

Additionally, the reduction in the thickness of the amorphous silicon solar cell 150 and the polycrystalline silicon solar cell 200 effectively reduces mechanical stress exerted on the layers incorporated therein. This effectively improves the reliability of the tandem thin film silicon solar cell.

### Sixth Embodiment

A tandem thin film solar cell in a sixth embodiment is almost identical to that in the third embodiment. The difference is that the thickness of the second transparent electrode 90, formed of ZnO between the polycrystalline silicon solar cell 200 and the rear electrode 100, is optimized to improve the stabilized conversion efficiency.

The optimization of the second transparent electrode 90 allows effectively reflecting the sunlight at the longer wavelength range (around 800 nm) which is not absorbed in the polycrystalline silicon solar cell 200, and thereby allows the sunlight at the longer wavelength range to efficiently re-enter the polycrystalline silicon solar cell 200. This effectively increases the power current of the polycrystalline silicon solar cell 200, and thereby improves the total stabilized conversion efficiency of the tandem thin film solar cell.

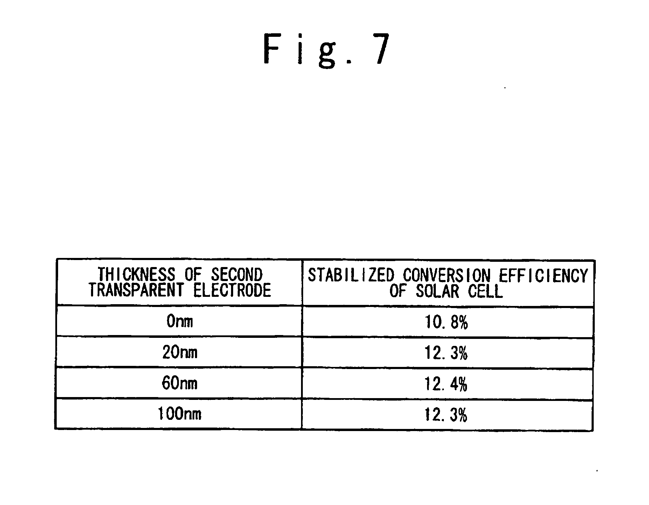

Fig. 7 is a table illustrating an association of the thickness of the second transparent electrode 90 with the stabilized conversion efficiency of the tandem thin film solar cell in this embodiment. The second transparent electrode 90 is substantially transparent with the absorption rate reduced below 1% for wavelengths of 600 t0 1200 nm.

As shown in Fig. 7, it is advantageous that the thickness of the second transparent electrode 90 is selected in a range of 20 to 100 nm for improving the stabilized conversion efficiency up to 12% or more.

As thus described, the thickness of the second transparent electrode 90 is optimized to improve the reflection coefficient for the sunlight of the longer wavelength range, which is reflected by the second transparent electrode 90 and the rear electrode 100 and re-enters the polycrystalline silicon solar cell 200. This effectively increases the power current of the polycrystalline silicon solar cell 200, and thereby provides a tandem thin film solar cell with superior stabilized conversion efficiency.

It is apparent that the present invention is not limited to the above-described embodiments, which may be modified and changed without departing from the scope of the invention, but only by the appended claims. Especially, it should be noted that the present invention is applicable to any solar cell incorporating an amorphous silicon solar cell and a polycrystalline silicon solar cell.

## Claims

1. A tandem thin film solar cell comprising:
a first conductive layer (20) formed on a transparent substrate (10) through which the sunlight enters the tandem thin film solar cell;
a first solar cell layer (150) formed on said first conductive layer (20); and
a second solar cell layer (200) covering said first solar cell layer (150),
wherein said first conductive layer (20) has surface irregularity, a pitch of said surface irregularity being in a range of 0.2 to 2.5 µm, and **characterised by** an amplitude of said surface irregularity being in a range of one-third to half of said pitch of said surface irregularity.

2. The tandem thin film solar cell according to claim 1, wherein said first solar cell layer (150) is an amorphous silicon solar cell mainly formed of amorphous silicon, said amorphous silicon solar cell including:
a first silicon layer (30) of first conductivity type selected out of P-type and N-type;
an I-type amorphous silicon layer (40); and
a second silicon layer (50) of second conductivity type different from said first conductivity type, and
wherein said second solar cell layer (200) is a polycrystalline silicon solar cell mainly formed of polycrystalline silicon, said polycrystalline silicon solar cell including:
a third silicon layer (60) of third conductivity type selected out of P-type and N-type;
an 1-type amorphous silicon layer (70); and
a fourth silicon layer (80) of fourth conductivity type different from said third conductivity type.

3. The tandem thin film solar cell according to claim 2, wherein a thickness of said first solar cell layer (150) is in a range of 200 to 400 nm, and
wherein a thickness of said second solar cell layer (200) is in a range of 1.5 to 3.0 µm.

4. The tandem thin film solar cell according to claim 2, further comprising:
an intermediate conductive layer (300) formed between said first solar cell layer (150) and said second solar cell layer (200).

5. The tandem thin film solar cell according to claim 4, wherein a thickness of said first solar cell layer (150) is in a range of 100 to 400 nm, and
wherein a thickness of said second solar cell layer (200) is in a range of 1.0 to 3.0 µm.

6. The tandem thin film solar cell according to claim 4, wherein said intermediate conductive layer (300) is mainly formed of material selected out of ZnC, SnO₂, and indium tin oxide, and
wherein said intermediate conductive layer (300) has a light absorption rate less than 1% at wavelengths of 600 to 1200 nm.

7. The tandem thin film solar cell according to claim 1, further comprising:
a second conductive layer (100) covering said second solar cell layer (200), said second conductive layer (100) being formed of silver.

8. The tandem thin film solar cell according to claim 7, further comprising:
a third conductive layer formed between said second solar cell layer (200) and said second conductive layer (100).

9. The tandem thin film solar cell according to claim 8, wherein said third conductive layer (90) is mainly formed of ZnO, having a thickness of 20 to 100 nm.

## Patentansprüche

1. Tandem-Dünnschicht-Solarzelle, umfassend:
eine erste leitfähige Schicht (20), die auf einem transparenten Substrat (10) ausgebildet ist, durch welches das Sonnenlicht in die Tandem-Dünnschicht-Solarzelle eintritt;
eine erste Solarzellenschicht (150), die auf der ersten leitfähigen Schicht (20) ausgebildet ist; und
eine zweite Solarzellenschicht (200), welche die erste Solarzellenschicht (150) abdeckt,
wobei die erste leitfähige Schicht (20) eine Oberflächenunregelmäßigkeit aufweist, ein Abstand der Oberflächenunregelmäßigkeit in einem Bereich von 0,2 bis 2,5 µm liegt, und **dadurch gekennzeichnet, dass** eine Amplitude der Oberflächenunregelmäßigkeit in einem Bereich von einem Drittel bis zu einer Hälfte des Abstands der Oberflächenunregelmäßigkeit liegt.

2. Tandem-Dünnschicht-Solarzelle nach Anspruch 1, wobei die erste Solarzellenschicht (150) eine amorphe Silicium-Solarzelle ist, die hauptsächlich aus amorphem Silicium gebildet ist, wobei die amorphe Silicium-Solarzelle umfasst:
eine erste Siliciumschicht (30) eines ersten Leitfähigkeitstyps, der aus einem P-Typ und einem N-Typ ausgewählt ist;
eine amorphe Siliciumschicht (40) vom I-Typ; und
eine zweite Siliciumschicht (50) eines zweiten Leitfähigkeitstyps, der vom ersten Leitfähigkeitstyp verschieden ist, und
wobei die zweite Solarzellenschicht (200) eine polykristalline Silicium-Solarzelle ist, die hauptsächlich aus polykristallinem Silicium gebildet ist, wobei die polykristalline Silicium-Solarzelle umfasst:
eine dritte Siliciumschicht (60) eines dritten Leitfähigkeitstyps, der aus einem P-Typ und einem N-Typ ausgewählt ist;
eine amorphe Siliciumschicht (70) vom I-Typ; und
eine vierte Siliciumschicht (80) eines vierten Leitfähigkeitstyps, der vom dritten Leitfähigkeitstyp verschieden ist.

3. Tandem-Dünnschicht-Solarzelle nach Anspruch 2, wobei eine Dicke der ersten Solarzellenschicht (150) in einem Bereich von 200 bis 400 nm liegt, und
wobei eine Dicke der zweiten Solarzellenschicht (200) in einem Bereich von 1,5 bis 3,0 µm liegt.

4. Tandem-Dünnschicht-Solarzelle nach Anspruch 2, ferner umfassend:
eine leitfähige Zwischenschicht (300), die zwischen der ersten Solarzellenschicht (150) und der zweiten Solarzellenschicht (200) ausgebildet ist.

5. Tandem-Dünnschicht-Solarzelle nach Anspruch 4, wobei eine Dicke der ersten Solarzellenschicht (150) in einem Bereich von 100 bis 400 nm liegt, und
wobei eine Dicke der zweiten Solarzellenschicht (200) in einem Bereich von 1,0 bis 3,0 µm liegt.

6. Tandem-Dünnschicht-Solarzelle nach Anspruch 4, wobei die leitfähige Zwischenschicht (300) hauptsächlich aus einem Material gebildet ist, das aus ZnO, SnO₂ und Indium-Zinnoxid ausgewählt ist, und
wobei die leitfähige Zwischenschicht (300) eine Lichtabsorptionsrate von weniger als 1 % bei Wellenlängen von 600 bis 1200 nm aufweist.

7. Tandem-Dünnschicht-Solarzelle nach Anspruch 1, ferner umfassend:
eine zweite leitfähige Schicht (100), welche die zweite Solarzellenschicht (200) abdeckt, wobei die zweite leitfähige Schicht (100) aus Silber gebildet ist.

8. Tandem-Dünnschicht-Solarzelle nach Anspruch 7, ferner umfassend:
eine dritte leitfähige Schicht, die zwischen der zweiten Solarzellenschicht (200) und der zweiten leitfähigen Schicht (100) ausgebildet ist.

9. Tandem-Dünnschicht-Solarzelle nach Anspruch 8, wobei die dritte leitfähige Schicht (90) hauptsächlich aus ZnO gebildet ist und eine Dicke von 20 bis 100 nm aufweist.

## Revendications

1. Cellule solaire tandem à couches minces, comprenant :
une première couche conductrice (20) formée sur un substrat transparent (10), à travers laquelle la lumière solaire entre dans la cellule solaire tandem à couches minces ;
une première couche de cellule solaire (150) formée sur ladite première couche conductrice (20) ; et
une seconde couche de cellule solaire (200) recouvrant ladite première couche de cellule solaire (150),
dans laquelle ladite première couche conductrice (20) comporte une irrégularité de surface, un pas de ladite irrégularité de surface étant compris dans l'intervalle de 0,2 à 2,5 µm , et **caractérisée par** une amplitude de ladite irrégularité de surface comprise dans l'intervalle d'un tiers à la moitié dudit pas de ladite irrégularité de surface.

2. Cellule solaire tandem à couches minces selon la revendication 1, dans laquelle ladite première couche de cellule solaire (150) est une cellule solaire en silicium amorphe principalement formée de silicium amorphe, ladite cellule solaire en silicium amorphe comprenant :
une première couche de silicium (30) d'un premier type de conductivité choisi entre le type P et le type N ;
une couche de silicium amorphe (40) du type 1 ; et
une deuxième couche de silicium (50) d'un deuxième type de conductivité différent dudit premier type de conductivité, et
dans laquelle ladite seconde couche de cellule solaire (200) est une cellule solaire en silicium polycristallin principalement formée de silicium polycristallin, ladite cellule solaire en silicium polycristallin comprenant :
une troisième couche de silicium (60) d'un troisième type de conductivité choisi entre le type P et le type N ;
une couche de silicium amorphe (70) du type 1 ; et
une quatrième couche de silicium (80) d'un quatrième type de conductivité différent dudit troisième type de conductivité.

3. Cellule solaire tandem à couches minces selon la revendication 2, dans laquelle une épaisseur de ladite première couche de cellule solaire (150) est comprise dans l'intervalle de 200 à 400 nm, et
dans laquelle une épaisseur de ladite seconde couche de cellule solaire (200) est comprise dans l'intervalle de 1,5 à 3,0 µm.

4. Cellule solaire tandem à couches minces selon la revendication 2, comprenant en outre :
une couche conductrice intermédiaire (300) formée entre ladite première couche de cellule solaire (150) et ladite seconde couche de cellule solaire (200).

5. Cellule solaire tandem à couches minces selon la revendication 4, dans laquelle une épaisseur de ladite première couche de cellule solaire (150) est comprise dans l'intervalle de 100 à 400 nm, et
dans laquelle une épaisseur de ladite seconde couche de cellule solaire (200) est comprise dans l'intervalle de 1,0 à 3,0 µm.

6. Cellule solaire tandem à couches minces selon la revendication 4, dans laquelle ladite couche conductrice intermédiaire (300) est principalement formée d'une matière choisie entre le ZnO, SnO₂ et l'oxyde d'indium étain, et
dans laquelle ladite couche conductrice intermédiaire (300) a un coefficient d'absorption de la lumière inférieur à 1% aux longueurs d'onde de 600 à 1200 nm.

7. Cellule solaire tandem à couches minces selon la revendication 1, comprenant en outre :
une deuxième couche conductrice (100) recouvrant ladite seconde couche de cellule solaire (200), ladite deuxième couche conductrice (100) étant formée d'argent.

8. Cellule solaire tandem à couches minces selon la revendication 7, comprenant en outre :
une troisième couche conductrice (90) formée entre ladite deuxième couche de cellule solaire (200) et ladite seconde couche conductrice (100).

9. Cellule solaire tandem à couches minces selon la revendication 8, dans laquelle ladite troisième couche conductrice (90) est principalement formée de ZnO, ayant une épaisseur de 20 à 100 nm.
